# EUROPEAN PATENT APPLICATION

(11) **EP 0 762 629 A1**
(43) Date of publication of application: **12.03.1997**
(21) Application number: 96114197.5
(22) Date of filing: 04.09.1996
(51) Int. Cl.: H03F 1/02

(54) **Low voltage bias current compensation circuit**

(30) Priority: 05.09.1995 US 523588
(71) Applicant: RESOUND CORPORATION, Redwood City, CA 94063 (US)
(72) Inventor: Koskowich, Gregory M., Pleasanton, California 96588 (US)
(74) Representative: Fleuchaus, Leo, Dipl.-Ing.

(57) **Abstract**

A bias current cancellation circuit for a low voltage environment is provided. The bias current compensation circuit includes a first transistor and a second transistor forming a differential transistor pair and circuitry for establishing a predetermined tail current in said differential transistor pair. Circuitry is connected to said differential transistor pair for causing substantially equal currents to flow through the first transistor and the second transistor and for supplying a base current to one of the first transistor and the second transistor. Further circuitry is provided for replicating the base current to produce a replicated current and for supplying the replicated current as an output of the bias current compensation current. The total voltage drop in the circuit is two VCEs and one VBE. The circuit is therefore well-adapted to a low-voltage environment.

## Description

### BACKGROUND OF THE INVENTION

### 1. Field of the Invention

The present invention relates to bias current compensation circuits.

### 2. State of the Art

Bias current compensation circuits are known, as described, for example, in Gray et al., *Analysis and Design of Analog Integrated Circuits* (Third Ed., Wiley, 1993), in particular Section 6.4.2, Design of Low-Input-Current Operational Amplifiers. As described therein, a bias current compensation circuit is used to supply to an amplifier bias current that would otherwise have to be supplied by the external circuit, thereby loading the circuit and disturbing its operation.

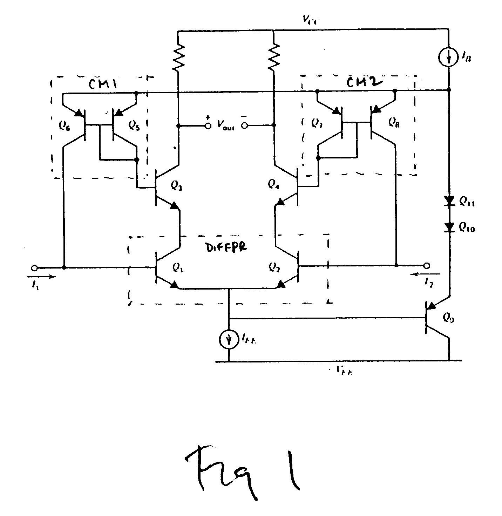

A typical known bias current cancellation circuit using bipolar transistors is shown in Figure 6.35 of Gray, reproduced herein as Figure 1. Referring to Figure 1, in the known bias current cancellation circuit, a differential transistor pair Q1 and Q2 have their emitters connected in common to a current source IEE flowing to ground, or VEE. The transistors Q1 and Q2 of the differential pair are assumed to receive respective base currents I1 and I2, the bias currents to be canceled, from an external circuit. The transistors Q1 and Q2 are connected in series with respective transistors Q3 and Q4, which are connected through resistors to an operating voltage VCC. A first current mirror CM1 comprising PNP transistors Q5 and Q6 is connected to a current source IB and to the bases of the transistors Q1 and Q3. A second current mirror CM2 comprising PNP transistors Q7 and Q8 is connected to the current source IB and to the bases of the transistors Q2 and Q4. A PNP transistor Q9 is connected at its collector to VEE and has its emitter connected through diodes Q10 and Q11 to the current source IB. The base of the transistor Q9 is connected to the emitter of the differential pair Q1 and Q2.

As described in Gray, in operation, the transistor Q9, together with diodes Q10 and Q11, serve to bias the emitters of Q6 and Q8 at a potential three diode drops more positive than the emitters of Q1 and Q2. Diodes Q7 and Q5 are forward biased since they carry the base currents of Q3 and Q4, and so the bases of Q3 and Q4 are two diode drops above the emitters of Q1 and Q2. The emitters of Q3 and Q4 are then one diode drop above the emitters of Q1 and Q2, and these input transistors operate at approximately zero collector-base bias. Assuming the current gain beta of the NPN devices to be large, the collector current of Q3 and Q4 are approximately equal to the collector currents of input transistors Q1 and Q2. If the NPN betas are all the same, then the base currents of Q3 and Q4 are the same as the base currents of Q1 and Q2. The PNP current sources, Q5, Q6, Q7 and Q8, then take this base current and supply an identical current back into the base of Q1 and Q2. If the PNP betas are large, the cancellation is precise.

In practice, the PNP betas are rather low because the PNP devices themselves operate at a very low current level. Also, the betas of the NPN transistors do not match precisely. As a result, a mismatch of from 5 to 20 percent typically exists between the base current of Q1 and the collector current of Q6, which is supposed to cancel it.

The resulting residual input current is typically one-fifth to one twentieth of the original uncompensated input current. However, the input offset current and the input noise current are increased by the cancellation circuitry. More importantly for purposes of some low voltage applications, the cancellation circuitry requires more voltage headroom than is available and is therefore unusable. For example, in hearing aid applications, typically a single battery is used having a voltage of between 1 and 1.5V. The circuit of Figure 1 is unsuitable for such a low-voltage environment. In particular, the VBE drops of Q7 and Q4 combined with the VCE drops of Q2 and IEE current source (typically another VCE) require more voltage than is available with the single battery.

### SUMMARY OF THE INVENTION

The present invention, generally speaking, provides a bias current cancellation circuit for a low voltage environment of the type described. In accordance with a particular embodiment of the invention, a bias current compensation circuit includes a first transistor and a second transistor forming a differential transistor pair and circuitry for establishing a predetermined tail current in said differential transistor pair. Circuitry is connected to said differential transistor pair for causing substantially equal currents to flow through the first transistor and the second transistor and for supplying a base current to one of the first transistor and the second transistor. Further circuitry is provided for replicating the base current to produce a replicated current and for supplying the replicated current as an output of the bias current compensation current. The total voltage drop in the circuit is two VCEs and one VBE. The circuit is therefore well-adapted to a low-voltage environment.

### BRIEF DESCRIPTION OF THE DRAWINGS

The present invention may be further understood from the following description in conjunction with the appended drawing. In the drawing:
Figure 1 is a schematic diagram of a known bias current cancellation circuit;
Figure 2 is a schematic diagram of a bias current cancellation circuit in accordance with the present invention; and
Figure 3 is a schematic diagram of an exemplary circuit compensated using the bias current cancellation circuit of Figure 2.

### DETAILED DESCRIPTION OF THE PREFERRED EMBODIMENT

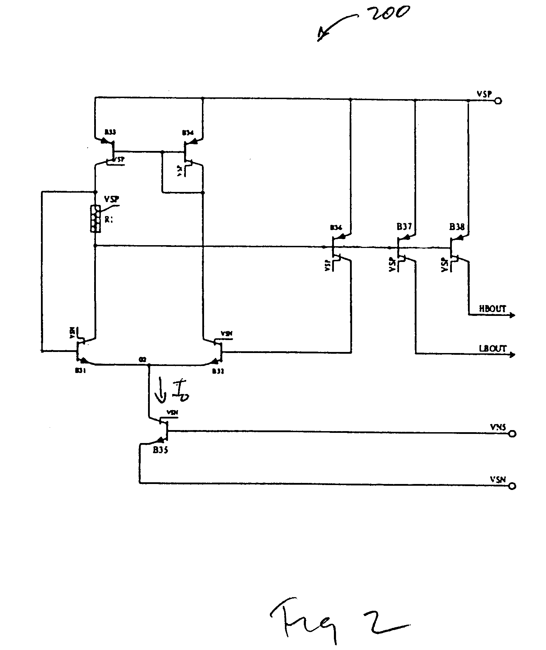

Referring now to Figure 2, a schematic of an embodiment of the present bias current cancellation circuit is shown. Unlike the bias current cancellation circuit of Figure 1, which produces a compensation current in response to the collector current of the input transistor, the bias current cancellation circuit of Figure 2 has no input per se and produces as its only output one or more bias cancellation currents. In the illustrated embodiment, the circuit of Figure 2 produces two bias cancellation outputs, but like circuits producing a greater or lesser number of outputs can be made by altering the circuit of Figure 2 only slightly.

In the circuit of Figure 2, a differential transistor pair B31 and B32 have their emitters connected in common to a current source (transistor B35) that causes a current I0 to flow to ground, or VSN. A current mirror CM comprising PNP transistors B33 and B34 is connected with the emitters of the transistor B33 and the transistor B34 connected to an operational voltage VSP and respective collectors of the transistor B33 and the transistor B34 connected to respective collectors of the transistor B31 and the transistor B32. In the case of the transistor B33, the collector of the transistor B33 is connected to the collector of the transistor B31 through an integrated resistor R1. The bases of the transistor B33 and the transistor B34 are connected together. Furthermore, the collector of the transistor B34 is connected to the base of the transistor B34 (and hence of the transistor B33). The current mirror CM causes the current I0 to be equally divided between the two branches of the differential pair.

A transistor B36 is connected so as to supply base current to the transistor B32. In particular, the emitter of the transistor B36 (a PNP device) is connected to the operational voltage VSP, the collector of the transistor B36 is connected to the base of the transistor B32, and the base of the transistor B36 is connected to the collector of the transistor B31.

Note that the base of the transistor B31 is connected to the collector of the transistor B31 through the resistor R1. The resistor R1 causes a sufficiently low voltage to be developed at the collector of the transistor B31 to cause the transistor B34 to conduct so as to supply base current to the transistor B32.

Assuming adequate device matching, the base current IB into the transistor B32 will be virtually identical to a base current flowing into another an NPN transistor of another differential pair having substantially the same tail current I0. The base voltage of the transistor B35 is set such that the collector current I0 is a known value (for example, 5uA) equal to the tail current of the differential pair which is to be compensated.

By connecting a transistor B37 in current mirror configuration with the transistor B36, the base current of the transistor B32 (substantially equal to the base current of the transistor to be compensated) is replicated and output at an output terminal LBOUT. If two transistors are to be compensated, a further transistor B38 may be provided, connected in similar fashion as the transistor B37, in order to produce a further replicated base compensation current at an output terminal HBOUT, and so on for additional outputs.

Hence the circuit of Figure 2 creates two currents, one at each of HBOUT and LBOUT, which are equal to the base current of an NPN transistor used in a differential pair biased with a tail current equal to the collector current of the transistor B35.

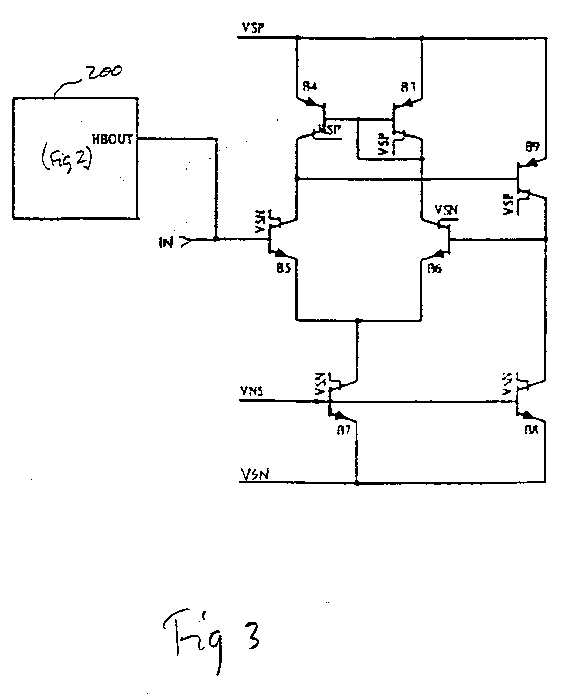

A schematic diagram of an exemplary circuit compensated using the bias current cancellation circuit of Figure 2 is shown in Figure 3. The particulars of the circuit of Figure 3 are not important except to note that, since the transistor B7 in Figure 3 is biased for 5uA of collector current, the HBOUT current produced by the bias compensation circuit 200 should match the base current of the transistor B5.

In a test circuit like that of Figure 3, the power supply voltage was swept from 1.0V to 1.6V to verify that the base current compensation circuit would operate satisfactorily over process variations. The worst case mismatch current was determined to be approximately 9.5nA at 1.6V. Typical performance was much better.

The base current in Figure 3 will vary over process variations (40 < βn < 200) from 12.5nA to 62.5nA. The circuit of Figure 2 tracks this current gain variation. because it is affected by the same process variations.

It will be appreciated by those of ordinary skill in the art that the present invention can be embodied in other specific forms without departing from the spirit or essential character thereof. The disclosed embodiments are therefore considered in all respects to be illustrative and not restrictive. The scope of the invention is indicated by the appended claims, and all changes which come within the meaning and range of equivalents thereof are intended to be embraced therein.

## Claims

1. A bias current compensation circuit comprising: a first transistor and a second transistor forming a differential transistor pair;
means for establishing a predetermined tail current in said differential transistor pair;
means connected to said differential transistor pair for causing substantially equal currents to flow through said first transistor and said second transistor;
means for supplying a base current to one of said first transistor and said second transistor; and
means for replicating said base current to produce a replicated current and for supplying said replicated current as an output of said bias current compensation current.

2. The apparatus of claim 1, wherein said means for establishing comprises a transistor configured as a current source.

3. The apparatus of claim 1, wherein said means for causing substantially equal currents to flow comprises a current mirror.

4. The apparatus of claim 3, wherein said first and second transistors are NPN transistors, and wherein said current mirror comprises first and second PNP transistors each having an emitter coupled to a common operational voltage and having bases coupled to each other, a collector of said first PNP transistor being coupled to a collector of said first NPN transistor and a collector of said second PNP transistor being coupled to a collector of said second NPN transistor.

5. The apparatus of claim 4, wherein a base of said second PNP transistor is coupled to the collector thereof.

6. The apparatus of claim 4, wherein the collector of said first PNP transistor is coupled to the collector of said first NPN transistor through a resistor.

7. The apparatus of claim 7, wherein said means for supply a base current comprises a PNP transistor having an emitter coupled to said operational voltage, a collector coupled to a base of said second NPN transistor, and a base coupled to the collector of said first NPN transistor.

8. The apparatus of claim 7, wherein said means for replicating comprises a PNP transistor having an emitter coupled to said operational voltage, a base coupled to the collector of said first NPN transistor, and a collector at which said replicated current is produced.
